# FASCICULE DE BREVET EUROPEEN

(11) **EP 1 742 075 B1**
(45) Date de publication et mention de la délivrance du brevet: **23.09.2009**
(21) Numéro de dépôt: 06116762.3
(22) Date de dépôt: 07.07.2006
(51) Int. Cl.: G01R 31/317, G01R 31/3185

(54) **Procédé de test d'un circuit électronique comprenant un mode de test sécurisé par l'utilisation d'une signature, et circuit électronique associé.**
Verfahren zum Testen eines elektronischen Schaltkreises, das einen mittels Verwendung einer Signatur gesicherten Testmodus umfasst, und zugehöriger elektronischer Schaltkreis
Test method for an electronic circuit comprising a signature-based secure test mode and associated electronic circuit.

(30) Priorité: 08.07.2005 FR 0507282
(43) Date de publication de la demande: 10.01.2007
(73) Titulaire: STMicroelectronics S.A., 92120 Montrouge (FR)
(72) Inventeur: Hely, David c/o STMICROELECTRONICS S.A., 57070, METZ (FR); Bancel, Frédéric STMICROELECTRONICS S.A., 57070, METZ (FR)
(74) Mandataire: Bouchet, Geneviève

(56) Documents cités:
- EP-A- 1 439 398
- EP-A- 1 443 338
- US-A- 5 357 572
- US-A1- 2003 206 627
- US-A1- 2004 133 832
- HELY D ET AL: "Test Control for Secure Scan Designs" TEST SYMPOSIUM, 2005. EUROPEAN TALLINN, ESTONIA 22-25 MAY 2005, PISCATAWAY, NJ, USA,IEEE, 22 mai 2005 (2005-05-22), pages 190-195, XP010801332 ISBN: 0-7695-2341-2
- WILLIAMS M J Y ET AL: "ENHANCING TESTABILITY OF LARGE-SCALE INTEGRATED CIRCUITS VIA TEST POINTS AND ADDITIONAL LOGIC" IEEE TRANSACTIONS ON COMPUTERS, IEEE SERVICE CENTER, LOS ALAMITOS, CA, US, vol. C-22, no. 1, janvier 1973 (1973-01), pages 46-60, XP009037345 ISSN: 0018-9340

## Description

L'invention concerne, de façon générale, les circuits électroniques intégrés synchrones munis de moyens de logique combinatoire, de bascules, et de moyens de test.

Plus précisément, l'invention concerne un circuit électronique comprenant une pluralité de cellules configurables configurées en fonction d'un signal de commande de chaînage :
- soit dans un état chaîné dans lequel les cellules configurables sont fonctionnellement connectées en chaîne pour former un registre à décalage, si le signal de commande de chaînage est dans un premier état,
- soit dans un état fonctionnel dans lequel les cellules configurables sont fonctionnellement reliées à des cellules logiques avec lesquelles elles coopèrent pour former au moins un circuit logique, si le signal de commande de chaînage est dans un deuxième état.

Il est aujourd'hui bien connu de vérifier le fonctionnement correct des éléments fonctionnels d'un circuit intégré en imposant et / ou en déterminant, à des instants prédéfinis, des valeurs de données présentes en certains points internes de ce circuit intégré. Une telle technique de test des chemins internes d'un circuit intégré (désignée par "scanpath" ou "internal scan method" en langue anglaise) est par exemple décrite dans la publication de M. Williams et J. Angel, intitulée "Enhancing Testability of LSI Circuits Via Test Points and Additional Logic, IEEE Transactions on Computers, vol. C-22, no.1; Janvier 1973".

Selon cette technique, chacune des bascules du circuit logique, dont il est utile de connaître l'état et / ou d'imposer le contenu durant le fonctionnement standard du circuit intégré, est dotée à son entrée d'un multiplexeur. Les différentes bascules et les multiplexeurs qui leur sont associés constituent ainsi autant de cellules configurables dont les accès sont contrôlés par ces multiplexeurs.

Les multiplexeurs de ces différentes cellules configurables sont collectivement commandés par un contrôleur d'accès ou "contrôleur TAP" ("TAP" pour "Test Access Port" en langue anglaise) qui, en fonction d'un signal de commande définissant un mode de fonctionnement choisi, utilise cet ensemble de cellules configurables soit comme un circuit fonctionnel standard, intégré au circuit logique qu'il forme avec les cellules logiques, soit comme un circuit de test.

Pour ce faire, le contrôleur TAP reçoit sur différents conducteurs de commande, et / ou adresse sur différents conducteurs de commande par lesquels il est relié aux différentes cellules configurables, des signaux de commande, tels qu'un signal de commande de mode, un signal de commande de chaînage ou encore un signal de commande de propagation de données, qui autorisent à modifier et / ou modifient les chemins de circulation des données au sein du circuit intégré et qui permettent ainsi la capture de ces données par le contrôleur, en vue de leur analyse ultérieure.

En mode de fonctionnement standard, le contrôleur TAP pilote donc les multiplexeurs des cellules configurables de manière que les bascules de ces cellules soient connectées à des cellules logiques environnantes pour définir un ou plusieurs sous-ensembles fonctionnels du circuit intégré.

Dans le mode de test, qui est normalement déclenché à réception par le contrôleur TAP d'un signal de commande de passage en mode de test, ce contrôleur produit un signal de commande de chaînage pour connecter en série les bascules des cellules configurables de manière à former un registre à décalage.

Ce registre comporte notamment une entrée série et une sortie série respectivement connectées à une sortie et à une entrée du contrôleur TAP, ainsi qu'une entrée d'horloge recevant un signal d'horloge pour cadencer le flot de données circulant dans le registre à décalage.

Dans un premier temps, le contrôleur TAP charge en série des données dans les bascules des cellules configurables par l'entrée du registre à décalage que forment ces cellules configurables.

Puis, le contrôleur TAP change la commutation des multiplexeurs pour former le circuit fonctionnel, et commande l'exécution d'un ou plusieurs cycles d'horloge par ce circuit fonctionnel. Dans cette phase, les données chargées dans les bascules des cellules configurables sont traitées par le circuit fonctionnel.

Le contrôleur change alors une nouvelle fois la commutation des multiplexeurs pour former à nouveau le registre à décalage et récupère, en série sur la sortie de ce registre à décalage, les données mémorisées dans les bascules des cellules configurables durant le dernier cycle d'horloge.

En dépit de l'intérêt confirmé de cette technique de test, son application pratique peut en certaines circonstances s'avérer problématique, notamment sur les circuits intégrés qui traitent des données secrètes.

En effet, dans la mesure où l'activation du mode de test peut permettre à un fraudeur de lire le contenu des bascules des cellules configurables, cette technique de test présente a priori l'inconvénient de rendre de tels circuits très vulnérables à une utilisation frauduleuse.

Par exemple, en stoppant à divers moments un processus de chargement interne de données secrètes dans le circuit intégré et en déchargeant le contenu du registre à décalage, un fraudeur pourra obtenir des informations sur des données secrètes, voire les reconstituer.

En activant le mode de test, un fraudeur pourra également accéder en écriture aux bascules des cellules configurables pour insérer des données frauduleuses, ou bien pour placer le circuit intégré dans une configuration non autorisée. Il pourra ainsi par exemple accéder à un registre contrôlant un organe sécuritaire tel qu'un capteur pour le désactiver. Il pourra également injecter une donnée erronée en vue d'obtenir de l'information sur une donnée secrète.

La fraude peut en fait adopter deux stratégies différentes : la première consiste à prendre le contrôle du contrôleur TAP et à observer sur les plots externes le contenu des cellules du registre à décalage ; la seconde consiste à prendre le contrôle des cellules configurables en les excitant par micro-sondage de manière à simuler le pilotage de ces cellules par les signaux de commande qu'émet le contrôleur TAP.

On connaît par le document EP 1 443 338 - Al un circuit logique comportant un dispositif de test. La mise en mode de test est conditionnée à l'introduction d'une clé privée.

Le document « Test control for secure scan designs » extrait des pages 190 à 195 de « Proceedings of the European Test Symposium (ETS'05) 2005 » expose des dispositions pour sécuriser le passage en mode test d'un circuit par la comparaison d'une signature introduite avec une signature stockée.

Le document US 2004/0133832 montre un circuit intégré et une méthode pour le tester. Le circuit comporte une entrée d'un vecteur pour un « scan testing » et une unité d'autorisation. Le circuit reste dans un mode dit « safe mode » si le vecteur introduit ne correspond pas à celui attendu pour passer en mode de test. La validation est basée sur un décodage du vecteur entré sur la base de clés publique et privée.

Le but de la présente invention est précisément de proposer un procédé et un circuit électronique conçus pour faire échec à une tentative de fraude, quelle que soit la stratégie de fraude utilisée.

Pour atteindre cet objectif, l'invention prévoit de faire précéder un mot de données de test d'une signature numérique, l'ensemble composé de la signature numérique et d'un mot de données formant une séquence de test. La signature est vérifiée avant l'utilisation du mot de données.

L'invention a pour objet un procédé tel que défini dans la revendication 1.

Ainsi, il n'est plus possible d'entrer des données dans le registre à décalage sans connaître la signature, ce qui met en échec toute tentative de fraude selon le premier type.

Selon un mode préféré de mise en oeuvre, la vérification de la signature se fait par comparaison de tout ou partie de la signature entrée avec un mot de référence associé.

Selon un autre aspect de l'invention, on prévoit de produire également le signal d'alerte lorsque le signal de commande de chaînage est incohérent avec un signal de commande de test reçu par un circuit de commande produisant le signal de commande de chaînage. Ainsi, on fait échec à toute tentative de fraude selon le second type.

Le procédé selon l'invention est de préférence mis en oeuvre dans un circuit électronique selon l'invention, comprenant les éléments décrits dans le préambule ci-dessus, et essentiellement caractérisé en ce qu'il comprend également un circuit de détection agencé pour, si le signal de commande de chaînage est dans le premier état pendant un premier temps T1, produire un signal d'alerte si le contenu d'un ensemble de X1 cellules configurables ne correspond pas à une première valeur de référence.

Le temps T1 est le temps de chargement dans le registre à décalage de tout ou partie des bits du mot de signature, X1 est un ensemble de cellules configurables, successives ou non, dans lesquelles sont entrés tout ou partie des bits de la signature, chaque cellule mémorisant un seul bit de la de signature.

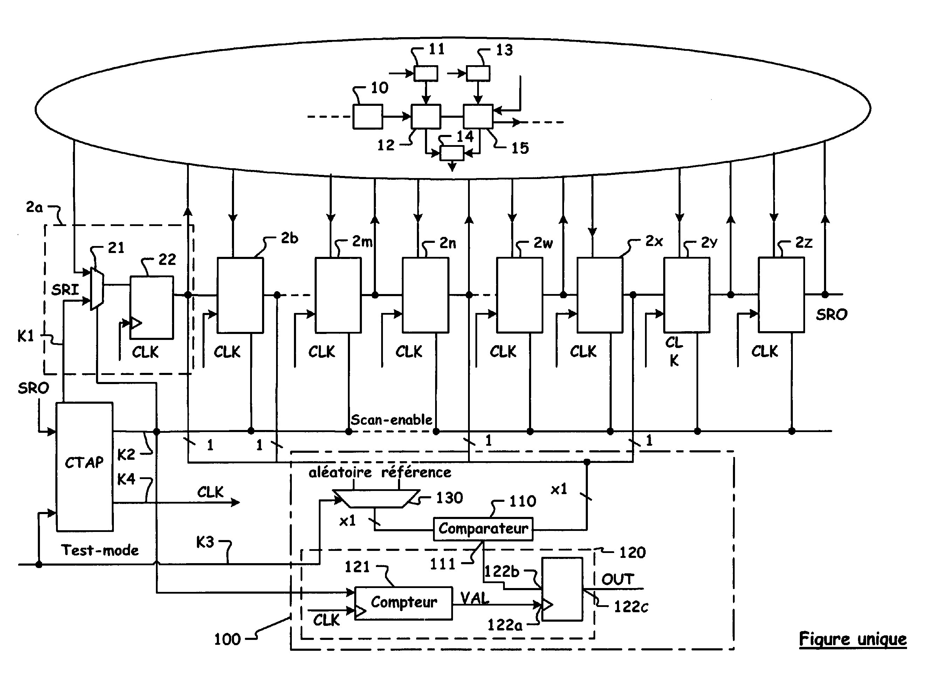

D'autres caractéristiques et avantages de l'invention ressortiront clairement de la description qui en est faite ci-après, à titre indicatif et nullement limitatif, en référence à l'unique figure annexée, qui est un schéma illustrant un circuit électronique conforme à l'invention.

Comme annoncé précédemment, l'invention concerne un circuit électronique doté de moyens de test internes. Un tel circuit comprend typiquement une pluralité de cellules logiques telles que les cellules 10 à 15, une pluralité de cellules configurables telles que les cellules 2a, 2b, ..., 2m, 2n, ..., 2w, 2x, 2y et 2z, une pluralité de conducteurs de commande tels que les conducteurs K1 à K4, ainsi éventuellement qu'un circuit de commande tel qu'un contrôleur d'accès CTAP, qui peut aussi, toutefois, être externe au circuit électronique considéré.

Chacune des cellules configurables telles que 2a à 2z comprend au moins un multiplexeur 21 et au moins une bascule 22 (par souci de clarté, seule la cellule 2a est détaillée sur la figure).

Les conducteurs de commande K1 à K4, dont certains au moins sont reliés aux cellules configurables 2a à 2z, servent à la transmission de signaux de commande sélectivement reçus et / ou émis en fonctionnement par le circuit de commande CTAP, tels qu'un signal de commande de passage en mode de test TEST_MODE qui active le circuit de commande CTAP, un signal de commande de chaînage SCAN_ENABLE qui chaîne les cellules configurables sous forme d'un registre à décalage, et un signal de commande CLK qui permet la propagation de données dans les cellules configurables.

En fonction de ces signaux de commande ou de certains au moins d'entre eux, les cellules configurables 2a à 2z adoptent soit un mode de fonctionnement standard, dans lequel elles sont fonctionnellement reliées à certaines au moins des cellules logiques 10 à 15 avec lesquelles elles coopèrent pour former un circuit logique LOG, soit un mode de test dans lequel ces cellules configurables 2a à 2z sont fonctionnellement connectées l'une à l'autre en chaîne pour former un registre à décalage.

Le passage des cellules configurables du mode de fonctionnement standard au mode de test est effectué par le pilotage des multiplexeurs 21 au moyen de certains au moins des signaux de commande délivrés par le circuit de commande CTAP.

Le registre à décalage 2a à 2z présente notamment une entrée de données SRI pilotée par une sortie du circuit de commande CTAP, une sortie de données SRO, reliée à une entrée du circuit de commande CTAP, et une entrée d'horloge (non spécifiquement représentée) pour recevoir un signal d'horloge CLK propre à cadencer le flot de données dans ce registre à décalage.

Typiquement, pour lancer un test, un signal TEST_MODE de commande de passage en mode de test doit d'abord être adressé au circuit de commande CTAP sur le conducteur de commande K3.

Le circuit de commande CTAP configure alors les cellules configurables 2a à 2z en registre à décalage par l'émission du signal de commande de chaînage SCAN_ENABLE.

Puis, par émission du signal de commande de propagation CLK, le circuit de commande CTAP charge en série des données de test dans les bascules 22 de ces cellules configurables à travers l'entrée SRI du registre à décalage.

Puis, par désactivation du signal de commande de chaînage SCAN_ENABLE, le circuit de commande CTAP reconfigure les cellules configurables 2a à 2z en élément fonctionnel du circuit logique LOG et commande l'exécution d'un ou plusieurs cycles d'horloge par cet élément fonctionnel, qui traite les données de test.

Par réactivation du signal de commande de chaînage SCAN_ENABLE, le circuit de commande CTAP reconfigure à nouveau les cellules configurables 2a à 2z en registre à décalage. Enfin, par émission du signal de commande de propagation CLK, le circuit de commande CTAP récupère, à la sortie SRO de ce registre, les données mémorisées dans les bascules 22 et issues du traitement des données de test par le circuit logique LOG.

Pour éviter notamment qu'un fraudeur ne puisse simuler une telle procédure de test en appliquant directement des signaux de commande sur les conducteurs K1 à K4, et / ou des données sur l'entrée SRI, et ne puisse récupérer ainsi frauduleusement les données mémorisées dans les bascules 22 et issues du traitement des données de test par le circuit logique LOG, l'invention prévoit de faire précéder les données de test d'une signature numérique, l'ensemble composé de la signature et des données de test formant une séquence de test.

Ainsi, selon le procédé de l'invention, par émission du signal de commande de propagation CLK, le circuit de commande CTAP charge tout d'abord en série la signature numérique dans le registre à décalage. La dite signature est vérifiée et, si la signature est correcte alors, par émission du signal CLK, le circuit de commande charge les données de test.

Selon un premier mode de mise en oeuvre, tous les bits de la signature sont chargés dans le registre puis, après le chargement complet, la signature est vérifiée.

Selon une variante, on vérifie tous les bits de la signature. Selon une autre variante, on vérifie seulement une partie des bits de la signature. Par exemple, on peut vérifier seulement les bits de rang 1, 2, 5 et 10 d'une signature de 10 bits, chargée dans les 10 premières cellules configurables du registre à décalage.

Pour vérifier une signature, les bits de la dite signature entrée (ou seulement une partie des dits bits, selon la variante choisie) sont comparés à des bits correspondants de la signature attendue.

Selon un autre mode de réalisation, les bits de signature chargés dans le registre sont vérifiés plusieurs fois, au fur et à mesure de leur chargement dans le registre, les vérifications successives se faisant en parallèle du chargement de la signature. Par exemple, lors du chargement d'une signature de 10 bits, on effectue :
- une 1^{ère} vérification après le chargement de 2 bits, au cours de laquelle on vérifie les bits contenus dans les cellules de rang 1 et 2,
- une 2^{ème} vérification après le chargement de 5 bits, au cours de laquelle on vérifie les bits contenus dans les cellules de rang 1, 2, et 5
- une 3^{ème} vérification après le chargement des 10 bits, au cours de laquelle on vérifie les bits contenus dans les cellules de rang 1, 2, 5 et 10

Chaque vérification de tout ou partie de la signature consiste à lire dans le registre les bits à vérifier et à comparer les dits bits à des bits correspondants d'une signature attendue, et à produire éventuellement le signal d'alerte selon le résultat de la comparaison.

Vérifier la signature en plusieurs fois permet notamment d'alerter au plus tôt dès qu'une fausse signature est détectée. Ainsi, si dans l'exemple ci-dessus, lors de la première vérification, si les deux premiers bits sont erronés, l'alerte est donnée immédiatement, sans attendre le chargement complet de tous les bits de la signature. Si, par hasard, un fraudeur connaît les deux premiers bits vérifiés, mais pas les suivants, alors une erreur sera signalée dès la deuxième vérification.

Pour utiliser une séquence de test selon l'invention, et notamment pour vérifier la signature précédant les données de test, le circuit électronique selon l'invention comprend un circuit de détection 100 agencé pour, si le signal SCAN_ENABLE est actif pendant un temps T1, produire un signal d'alerte si le contenu d'un ensemble de X1 cellules configurables ne correspond pas à une valeur de référence.

En d'autres termes, le circuit de détection 100 est agencé pour vérifier le contenu d'au moins une partie des cellules configurables lorsqu'elles sont configurées en registre à décalage à l'issue d'un temps T1, et plus précisément pour vérifier que les bits (ou au moins une partie des dits bits) chargés dans le registre à décalage à l'issue du temps T1 correspondent bien à une signature attendue (correspondant à la valeur de référence). Si les bits chargés dans le registre à décalage ne correspondent pas à une signature attendue, le circuit 100 produit un signal d'alerte OUT.

Le temps T1 est le temps nécessaire au chargement de tout ou partie, selon la variante choisie, des bits de la signature dans le registre à décalage.

L'ensemble de X1 cellules configurables, adjacentes ou non, est l'ensemble des cellules configurables dont on vérifie le contenu, comprenant en l'occurrence tout ou partie des bits de la signature numérique.

Par exemple, selon une variante, l'ensemble de X1 cellules comprend les N premières cellules configurables du registre à décalage, dans lesquelles sont mémorisés tous les bits de la signature. Selon une autre variante, l'ensemble de X1 cellules configurables comprend les cellules configurables de rang 1, 2, 5 et 10 dans lesquelles sont mémorisés les bits de rang 1, 2, 5 et 10 de la signature.

Après vérification, le circuit de détection 100 produit le signal d'alerte OUT si le contenu du registre à décalage est différent d'une signature attendue. Selon une variante, le circuit 100 peut également interdire la continuation du chargement des données de test dans le registre à décalage. Pour cela, le circuit 100 peut :
- réinitialiser les cellules configurables (pour effacer leur contenu) et / ou
- changer l'état du signal de commande de chaînage SCAN_ENABLE (pour reconfigurer les cellules configurables en mode de fonctionnement normal) et / ou
- inhiber le signal CLK de propagation de données, de sorte à interdire toute propagation de données, pour mettre le circuit dans un état de blocage total.

Selon un mode de réalisation, par exemple approprié pour le cas où on vérifie les bits de la signature une seule fois, par exemple à la fin du chargement de tous les bits de la signature, le circuit de détection 100 selon l'invention comprend :
- un comparateur 110, pour comparer le contenu des X1 cellules configurables avec la première valeur de référence et produire le signal d'alerte si le contenu des X1 cellules configurables ne correspond pas à la première valeur de référence, et
- un circuit 120 de validation pour transmettre le signal d'alerte si le signal de commande de chaînage SCAN_ENABLE a été actif pendant le premier temps T1.

La première valeur de référence est par exemple mémorisée dans un registre ou une mémoire réinscriptible ; le choix du lieu de mémorisation est fonction notamment du degré de sécurité que l'on souhaite obtenir, de la possibilité éventuellement de modifier le mot de signature, etc.

Le temps T1 est le temps nécessaire au chargement dans le registre de la signature ou au moins d'une partie de la signature. T1 est égal au nombre de bits que l'on considère de la signature multiplié par la durée d'une période du signal d'horloge CLK qui cadence l'entrée des données dans le registre. Le circuit 120 active le comparateur après l'entrée dans le registre des bits de la signature.

La vérification de la signature se fait par comparaison de tout ou partie des bits de la signature avec un mot de signature attendu.

Dans l'exemple illustré, le circuit de validation 120 du comparateur 110 comprend :
- un compteur 121 activé par le signal de commande de chaînage SCAN_ENABLE, pour compter des impulsions d'un signal d'horloge CLK et produire un signal de validation VAL,
- une bascule 122, comprenant une entrée d'horloge 122a sur laquelle est appliqué le signal de validation VAL, une entrée de donnée 122b connectée à une sortie de donnée 111 du comparateur 121, et une sortie 122c sur laquelle est produit le signal d'alerte OUT.

Le compteur 121 a pour fonction ici de mesurer le temps T1 pendant lequel tout ou partie de la signature est susceptible d'être chargé dans le registre à décalage lorsque les cellules configurables sont en mode chaîné (SCAN_ENABLE dans le premier état, actif). A la fin du chargement de tout ou partie de la signature, le compteur produit le signal de validation VAL. La bascule 122 mémorise le signal de sortie du comparateur qu'elle reçoit sur son entrée de données 122b, et le reproduit sur sa sortie (c'est le signal d'alerte OUT) lorsqu'elle reçoit le signal de validation VAL.

Selon un autre mode de réalisation le circuit de détection 100 est également agencé pour, si le signal de commande de chaînage SCAN_ENABLE est dans le premier état pendant un deuxième temps T2 supérieur au premier temps T1,
- au bout du temps T1, produire le signal d'alerte si le contenu de l'ensemble de X1 cellules configurables ne correspond pas à la première valeur de référence, et
- au bout du temps T2, produire le signal d'alerte si le contenu d'un ensemble de X2 cellules configurables ne correspond pas à une deuxième valeur de référence.

Ce mode de réalisation est notamment approprié dans le cas où on teste deux fois au moins les bits de signature entrés dans le registre à des intervalles de temps différents, par exemple une première fois après avoir chargé une partie des bits de la signature et une fois après avoir chargé tous les bits de la signature.

Selon un second aspect de l'invention, le circuit de détection 100 selon l'invention est également agencé pour produire le signal d'alerte OUT si le signal de commande de chaînage SCAN_ENABLE est dans le premier état, actif, alors que le signal de commande de mode est dans le deuxième état, inactif. En d'autres termes, le circuit de détection selon l'invention détecte également une incohérence entre le signal de commande de mode TEST_MODE et le signal de commande de chaînage SCAN_ENABLE, signifiant que le circuit de commande a été court-circuité par un fraudeur.

Selon un mode de réalisation, le circuit de détection selon l'invention comprend pour cela en complément un circuit de sélection 130 pour appliquer sur une entrée de référence du comparateur :
- soit la première valeur de référence si le signal de commande de mode TEST_MODE est dans le premier état, c'est-à-dire actif,
- soit une valeur aléatoire si le signal de commande de mode TEST_MODE est dans le deuxième état, c'est-à-dire inactif.

La valeur aléatoire peut par exemple être fournie par un générateur de nombres aléatoires, qui est activé en même temps que le comparateur par le signal d'activation VAL. La valeur aléatoire est ainsi modifiée chaque fois que le comparateur est activé, de sorte qu'il n'est pas possible pour un fraudeur d'entrer une signature correcte, correspondant à la valeur aléatoire.

Ainsi, quelle que soit la signature choisie par un éventuel fraudeur, si les signaux TEST_MODE et SCAN_ENABLE sont incohérents (l'un inactif et l'autre actif), alors le signal d'alerte sera produit systématiquement.

## Revendications

1. Procédé de test d'un circuit électronique comprenant une pluralité de cellules configurables (2a, ..., 2Y, 2z) configurées en fonction d'un signal de commande de chaînage (SCAN_ENABLE) :
• soit dans un état chaîné dans lequel les cellules configurables sont fonctionnellement connectées en chaîne pour former un registre à décalage, si le signal de commande de chaînage est dans un premier état,
• soit dans un état fonctionnel dans lequel les cellules configurables sont fonctionnellement reliées à des cellules logiques (10 à 15) avec lesquelles elles coopèrent pour former au moins un circuit logique, si le signal de commande de chaînage est dans un deuxième état,
le procédé étant **caractérisé en ce qu'**il comprend les étapes suivantes, consistant à, lorsque le signal de commande de chaînage (SCAN_ENABLE) est dans le premier état,
• entrer successivement en série une signature dans le registre à décalage,
• vérifier la signature entrée et
• produire un signal d'alerte si la signature entrée est différente d'une signature attendue, ou entrer successivement en série dans le registre un mot de donnée sinon,
• l'étape de vérification de la signature étant réalisée en plusieurs sous-étapes réalisées successivement en parallèle de l'étape d'entrée de la signature, chaque sous-étape successive comprenant la vérification d'un nombre croissant de bits de la signature avec soit une première valeur de référence si un signal de commande de mode (TEST_MODE) est dans le premier état, soit une valeur aléatoire si le signal de commande de mode (TEST_MODE) est dans le deuxième état, et, selon le résultat de la vérification, la production du signal d'alerte ou la continuation de l'entrée de la signature.

2. Procédé selon la revendication 1, au cours duquel, pour vérifier tout ou partie des bits de la signature, on compare les dits bits avec un mot de référence associé.

3. Procédé selon l'une des revendications 1 ou 2, au cours duquel, simultanément à la production du signal d'alerte :
• les cellules configurables sont réinitialisées, et/ou
• le signal de commande de chaînage est changé d'état, et / ou
• le signal d'horloge (CLK) est inhibé.

4. Procédé selon l'une des revendications 1 à 3, au cours duquel le signal de commande de chaînage (SCAN_ENABLE) est produit dans le premier état par un circuit de commande tel qu'un contrôleur d'accès (TAP) lorsque le dit circuit de commande reçoit un signal de commande de mode (TEST_MODE) dans un premier état, le procédé comprenant également l'étape suivante, consistant à :
• produire le signal d'alerte (OUT) si le signal de commande de chaînage est dans le premier état alors que le signal de commande de mode est dans le deuxième état.

5. Circuit électronique comprenant une pluralité de cellules configurables (2a, ..., 2Y, 2z) configurées en fonction d'un signal de commande de chaînage (SCAN_ENABLE) :
• soit dans un état chaîné dans lequel les cellules configurables sont fonctionnellement connectées en chaîne pour former un registre à décalage, si le signal de commande de chaînage est dans un premier état,
• soit dans un état fonctionnel dans lequel les cellules configurables sont fonctionnellement reliées à des cellules logiques (10 à 15) avec lesquelles elles coopèrent pour former au moins un circuit logique, si le signal de commande de chaînage est dans un deuxième état,
**caractérisé en ce qu'**il comprend également un circuit de détection (100), le circuit de détection (100) comportant un comparateur (110) et un circuit de sélection (130) pour appliquer sur une entrée de référence du comparateur (110) :
• soit une première valeur de référence si le signal de commande de mode (TEST_MODE) est dans le premier état,
• soit une valeur aléatoire si un signal de commande de mode (TEST_MODE) est dans le deuxième état,
le comparateur (110) étant prévu pour comparer en plusieurs sous-étapes successives, en parallèle d'une étape d'entrée d'une signature en série dans le registre à décalage, la valeur sur l'entrée de référence avec la signature, chaque sous-étape successive comprenant la vérification d'un nombre croissant de bits de la signature contenus dans un ensemble de X1 cellules configurables parmi la pluralité de cellules configurables, le comparateur (110) produisant, si le signal de commande de chaînage (SCAN_ENABLE) est dans le premier état, un signal d'alerte (OUT) si la signature entrée est différente d'une signature attendue ou sinon la continuation de l'entrée de la signature.

6. Circuit selon la revendication 5, dans lequel, le circuit de détection (100) comprend un circuit (120) de validation pour transmettre le signal d'alerte si le signal de commande de chaînage (SCAN_ENABLE) a été dans le premier état pendant un premier temps T1.

7. Circuit selon la revendication 6, dans lequel le circuit de détection (100) est également agencé pour, si le signal de commande de chaînage (SCAN_ENABLE) est dans le premier état pendant un deuxième temps T2 supérieur au premier temps T1,
• au bout du temps T1, produire le signal d'alerte si le contenu de l'ensemble de X1 cellules configurables ne correspond pas à la première valeur de référence, et
• au bout du temps T2, produire le signal d'alerte si le contenu d'un ensemble de X2 cellules configurables ne correspond pas à une deuxième valeur de référence.

8. Circuit selon la revendication 7, dans lequel le circuit de validation (120) comprend :
• un compteur (121) activé par le signal de commande de chaînage (SCAN_ENABLE), pour compter des impulsions d'un signal d'horloge (CLK) et produire un signal de validation (VAL) à la fin du chargement de tout ou partie de la signature,
• une bascule (122), comprenant une entrée d'horloge (122a) sur laquelle est appliqué le signal de validation (VAL), une entrée de donnée (122b) connectée à une sortie de donnée (111) du comparateur (121), et une sortie (122c) sur laquelle est produit le signal d'alerte (OUT).

## Claims

1. A method for testing an electronic circuit comprising a plurality of configurable cells (2a,..., 2Y, 2z) configured according to a chaining command signal (SCAN_ENABLE):
• either in a chained state in which the configurable cells are functionally connected in a chain to form a shift register, if the chaining command signal is in a first state;
• or in a functional state in which the configurable cells are functionally linked to logic cells (10 to 15) with which they co-operate to form at least one logic circuit, if the mode command signal is in a second state,
**characterized in that** it comprises the following steps in which, when the chaining command signal (SCAN_ENABLE) is in the first state:
• a signature is entered successively in series into the shift register;
• the input signature is verified, and
• an alert signal is produced if the input signature is different from an expected signature, or else a data word is entered successively in series into the register,
• the step of verification of the signature is done in several sub-steps performed successively in parallel with the step of loading of the signature and, at each sub-step verification is carried out on an increasing number of bits of the signature with either a first reference value if a mode command signal (TEST_MODE) is in the first state, or a random value if the mode command signal (TEST_MODE) is in the second state, and, depending on the result of the verification, the warning signal is produced or the loading of the signature is continued.

2. A method according to one claim 1 wherein, to verify all or part of the bits of the signature, said bits are compared with an associated reference word.

3. A method according to one of the claims 1 or 2 wherein, simultaneously with the warning signal:
• the configurable cells are reset and/or
• the chaining command signal changes state and/or
• the clock signal (CLK) is inhibited.

4. A method according to one of the claims 1 to 3, wherein the chaining command signal (SCAN_ENABLE) is produced in the first state by a control circuit such as an access controller (TAP) when said control circuit receives a mode command signal (TEST_MODE) in a first state, the method also comprising the following step, consisting in:
• producing the warning signal (OUT) if the chaining command signal is in the first state while the mode command signal is in the second state.

5. An electronic circuit comprising a plurality of configurable cells (2a,..., 2Y, 2z) configured according to a chaining command signal (SCAN ENABLE):
• either in a chained state in which the configurable cells are functionally connected in a chain to form a shift register, if the chaining command signal is in a first state;
• or in a functional state in which the configurable cells are functionally linked to logic cells (10 to 15) with which they co-operate to form at least one logic circuit, if the chaining command signal is in a second state,
**characterized in that** it also comprises a detection circuit (100), the detection circuit (100) comprising a comparator (110) and a selection circuit (130) to apply to a reference input of comparator (110):
• either a first reference value if a mode command signal (TEST_MODE) is in the first state,
• or a random value if the mode command signal (TEST_MODE) is in the second state,
the comparator (110) being provided to compare in several sub-steps performed successively in parallel with a step of loading of a signature successively in series into the shift register, the value on the reference input with the signature, each sub-step comprising the verification of an increasing number of bits of the signature with either a first reference value stored in a set of X1 configurable cells among the plurality of configurable cells, the comparator (110) producing, if the chaining command signal (SCAN_ENABLE) is in the first state, a warning signal (OUT) if the signature is different from an expected signature, or else the continuation of loading of the signature.

6. A circuit according to claim 5, wherein the detection circuit (100) comprises a validation circuit (120) to transmit the warning signal if the chaining command signal (SCAN_ENABLE) has been in the first state during a first period of time T1.

7. Circuit according to claim 5, wherein the detection circuit (100) is also laid out so that, if the chaining command signal (SCAN_ENABLE) is in the first state during a second period of time T2 greater than the first period of time T1, then
• at the end of the period of time T1, it produces a warning signal if the content of the set of X1 configurable cells does not correspond to the first reference value, and
• at the end of the period of time T2, it produces a warning signal if the content of the set of X2 configurable cells does not correspond to a second reference value.

8. Circuit according to the claim 7, wherein the validation circuit (120) of the comparator (110) comprises:
• a counter (121) activated by the chaining command signal (SCAN_ENABLE), to count the pulses of a clock signal CLK and produce a validation signal (VAL) at the end of loading all or a part of the signature,
• a flip-flop circuit 122, comprising a clock input (122a) to which the validation signal (VAL) is applied, a data input (122b) connected to a data output (111) of the comparator (121), and an output (122c) at which the warning signal (OUT) is produced.

## Patentansprüche

1. Testverfahren für einen elektronischen Schaltkreis, mehrere konfigurierbare Zellen (2a, ..., 2y, 2z) umfassend, die in Abhängigkeit von einem Verkettungsbefehlssignal (SCAN_ENABLE) konfiguriert werden:
• entweder in einen verketteten Zustand, in dem die konfigurierbaren Zellen funktionsfähig zu einer Kette verbunden sind, um ein Schieberegister zu bilden, wenn sich das Verkettungsbefehlssignal in einem ersten Zustand befindet,
• oder in einen Betriebszustand, in dem die konfigurierbaren Zellen funktionsfähig mit Logikbausteinen (10 bis 15) verbunden sind, mit denen sie zusammenarbeiten, um mindestens eine Logikschaltung zu bilden, wenn sich das Verkettungsbefehlssignal in einem zweiten Zustand befindet,
wobei das Verfahren **dadurch gekennzeichnet ist, dass** es die folgenden Schritte umfasst, wenn sich das Verkettungsbefehlssignal (SCAN_ENABLE) im ersten Zustand befindet, darin bestehend,
• nacheinander seriell eine Signatur ins Schieberegister einzutragen,
• die eingetragene Signatur zu prüfen und
• ein Alarmsignal zu erzeugen, wenn die eingegebene Signatur sich von einer erwarteten Signatur unterscheidet, oder anderenfalls nacheinander seriell ein Datenwort in das Register einzutragen,
• wobei der Schritt der Prüfung der Signatur in mehreren Unterschritten erfolgt, die parallel zum Schritt des Eintragens der Signatur nacheinander ausgeführt werden, wobei jeder aufeinanderfolgende Unterschritt die Prüfung einer wachsenden Anzahl an Bits der Signatur mit entweder einem ersten Bezugswert umfasst, wenn sich ein Betriebsartbefehlssignal (TEST_MODE) im ersten Zustand befindet, oder mit einem Zufallswert, wenn sich das Betriebsartbefehlssignal (TEST_MODE) im zweiten Zustand befindet, und je nach dem Ergebnis der Prüfung die Erzeugung des Alarmsignals oder die Fortsetzung des Eintragens de Signatur.

2. Verfahren nach Patentanspruch 1, in dessen Verlauf zur Prüfung aller oder eines Teils der Bits der Signatur die genannten Bits mit einem zugeordneten Vergleichswort verglichen werden.

3. Verfahren nach einem der Patentansprüche 1 oder 2, in dessen Verlauf gleichzeitig mit der Erzeugung des Alarmsignals
• die konfigurierbaren Zellen reinitialisiert werden und/oder
• der Zustand des Verkettungsbefehlssignals geändert wird und/oder
• das Taktsignal (CLK) gesperrt wird.

4. Verfahren nach einem der Patentansprüche 1 bis 3, in dessen Verlauf das Verkettungsbefehlssignal (SCAN_ENABLE) im ersten Zustand durch eine Steuerschaltung erzeugt wird, wie etwa eine Zugriffssteuerung (TAP), wenn die genannte Steuerschaltung ein Betriebsartbefehlssignal (TEST_MODE) in einem ersten Zustand empfängt, wobei das Verfahren ebenfalls den folgenden Schritt umfasst, darin bestehend,
• das Alarmsignal (OUT) zu erzeugen, wenn sich das Verkettungsbefehlssignal im ersten Zustand befindet, während sich das Betriebsartbefehlssignal im zweiten Zustand befindet.

5. Elektronischer Schaltkreis, mehrere konfigurierbare Zellen (2a, ..., 2y, 2z) umfassend, die in Abhängigkeit von einem Verkettungsbefehlssignal (SCAN_ENABLE) konfiguriert werden:
• entweder in einen verketteten Zustand, in dem die konfigurierbaren Zellen funktionsfähig zu einer Kette verbunden sind, um ein Schieberegister zu bilden, wenn sich das Verkettungsbefehlssignal in einem ersten Zustand befindet,
• oder in einen Betriebszustand, in dem die konfigurierbaren Zellen funktionsfähig mit Logikbausteinen (10 bis 15) verbunden sind, mit denen sie zusammenarbeiten, um mindestens eine Logikschaltung zu bilden, wenn sich das Verkettungsbefehlssignal in einem zweiten Zustand befindet,
**dadurch gekennzeichnet, dass** er ebenfalls eine Erfassungsschaltung (100) umfasst, wobei die Erfassungsschaltung (100) einen Vergleicher (110) aufweist und eine Auswahlschaltung (130), um an einen Bezugseingang des Vergleichers (110) anzulegen:
• entweder einen ersten Bezugswert, wenn sich das Betriebsartbefehlssignal (TEST_MODE) im ersten Zustand befindet,
• oder einen Zufallswert, wenn sich ein Betriebsartbefehlssignal (TEST_MODE) im zweiten Zustand befindet,
wobei der Vergleicher (110) dafür vorgesehen ist, in mehreren aufeinander folgenden Unterschritten parallel zu einem Schritt des seriellen Eintragens einer Signatur ins Schieberegister, den Wert am Bezugseingang mit der Signatur zu vergleichen, wobei jeder der aufeinander folgenden Unterschritte die Prüfung einer wachsenden Anzahl an Bits der Signatur, die sich in einer Gesamtheit von X1 konfigurierbaren Zellen unter den mehreren konfigurierbaren Zellen umfasst, wobei der Vergleicher (110), wenn sich das Verkettungsbefehlssignal (SCAN_ENABLE) im ersten Zustand befindet, ein Alarmsignal (OUT) erzeugt, wenn sich die eingetragene Signatur von einer erwarteten Signatur unterscheidet, oder anderenfalls die Fortsetzung des Eintragens der Signatur.

6. Schaltkreis nach Patentanspruch 5, in dem die Erfassungsschaltung (100) eine Validationsschaltung (120) umfasst, um das Alarmsignal zu senden, wenn sich das Verkettungsbefehlssignal (SCAN_ENABLE) während eines ersten Zeitraums T1 im ersten Zustand befand.

7. Schaltkreis nach Patentanspruch 6, in dem die Erfassungsschaltung (100) ebenfalls dafür eingerichtet ist, wenn sich das Verkettungsbefehlssignal (SCAN_ENABLE) während eines zweiten Zeitraums T2, größer als der erste Zeitraum T1, im ersten Zustand befindet,
• am Ende des Zeitraums T1 das Alarmsignal zu erzeugen, wenn der Inhalt der Gesamtheit aus X1 konfigurierbaren Zellen nicht dem ersten Bezugswert entspricht, und
• am Ende des Zeitraums T2 das Alarmsignal zu erzeugen, wenn der Inhalt einer Gesamtheit aus X2 konfigurierbaren Zellen nicht einem zweiten Bezugswert entspricht.

8. Schaltkreis nach Patentanspruch 7, in dem die Validationsschaltung (120) umfasst:
• einen Zähler (121), der durch das Verkettungsbefehlssignal (SCAN_ENABLE) gestartet wird, um Impulse eines Taktsignals (CLK) zu zählen und am Ende des Ladens der ganzen oder eines Teils der Signatur ein Validationssignal (VAL) zu erzeugen,
• eine Kippschaltung (122), die einen Takteingang (122a) umfasst, an den das Validationssignal (VAL) angelegt wird, einen Dateneingang (122b), der an einen Datenausgang (111) des Vergleichers (121) angeschlossen ist, und einen Ausgang (122c), an dem das Alarmsignal (OUT) erzeugt wird.
